# FASCICULE DE BREVET EUROPEEN

(11) **EP 0 902 843 B1**
(45) Date de publication et mention de la délivrance du brevet: **29.03.2000**
(21) Numéro de dépôt: 97924080.1
(22) Date de dépôt: 13.05.1997
(51) Int. Cl.: C23C 14/00, C23C 14/58, C23C 14/48

(54) **PROCEDE DE REALISATION D'UN FILM MINCE DE MATERIAU SOLIDE ET APPLICATIONS DE CE PROCEDE**
REALISIERUNGSMETHODE EINER DÜNNSCHICHT AUS FESTEM MATERIAL UND ANWENDUNG DIESER METHODE
METHOD FOR MAKING A THIN FILM OF SOLID MATERIAL, AND USES THEREOF

(30) Priorité: 15.05.1996 FR 9606085
(43) Date de publication de la demande: 24.03.1999
(73) Titulaire: COMMISSARIAT A L'ENERGIE ATOMIQUE, 75015 Paris (FR)
(72) Inventeur: BRUEL, Michel, F-38113 Veurey (FR); ASPAR, Bernard, F-38140 Rives (FR)
(74) Mandataire: Des Termes, Monique
(86) Numéro de dépôt international: FR9700842
(87) Numéro de publication internationale: WO9743461

(56) Documents cités:
- EP-A- 0 563 667
- FR-A- 2 681 472
- JOURNAL OF ELECTRON MICROSCOPY, vol. 40, no. 3, 1 Juin 1991, pages 157-161, XP000265613 KIICHI HOJOU ET AL: "IN-SITU OBSERVATION OF STRUCTURAL DAMAGE IN SIC CRYSTALS INDUCED BY HYDROGEN ION IRRADIATION AND SUCCESSIVE ELECTRON IRRADIATION"
- ELECTRONICS LETTERS, vol. 31, no. 14, 6 Juillet 1995, page 1201/1202 XP000525349 BRUEL M: "SILICON ON INSULATOR MATERIAL TECHNOLOGY"

## Description

La présente invention concerne un procédé de réalisation d'un film mince de matériau solide, ce matériau pouvant être un diélectrique, un conducteur ou un semi-isolant. Il peut être cristallin ou non. Il peut s'agir d'un semiconducteur amorphe ou polycristallin dont les plans cristallographiques sont d'orientation quelconque. Ce matériau peut posséder des propriétés ferroélectriques, piézoélectriques, magnétiques, électro-optiques, etc.

Une application particulièrement intéressante du procédé selon l'invention concerne la réalisation de mémoires à condensateurs ferroélectriques.

On connaît de nombreux procédés de réalisation de films minces de matériau solide. Ces procédés dépendent de la nature du matériau et de l'épaisseur du film désiré. On peut ainsi déposer des films minces d'un matériau solide sur la surface d'une pièce par projection, pulvérisation, électrodéposition, etc. On peut aussi obtenir un film mince en amincissant une plaquette du matériau désiré par abrasion mécanochimique ou chimique, le film mince obtenu étant ensuite collé ou fixé sur une pièce servant de support.

Généralement, la fixation d'un film mince sur la surface d'une pièce est destinée à modifier superficiellement les propriétés de la pièce.

Dans le domaine des semiconducteurs, on est aussi quelquefois amené à réaliser des films minces semiconducteurs, par exemple pour fabriquer des substrats dits "Silicium Sur Isolant". Différentes méthodes de réalisation de films minces semiconducteurs ont été développées. L'une des méthodes les plus récentes est basée sur le fait que l'implantation d'ions d'un gaz rare ou d'hydrogène dans un matériau semiconducteur induit la formation de zones fragilisées à une profondeur voisine de la profondeur moyenne de pénétration des ions. Le document FR-A-2 681 472 divulgue un procédé qui utilise cette propriété pour obtenir un film mince de matériau semiconducteur. Ce procédé consiste à soumettre une plaquette du matériau semiconducteur désiré et comportant une face plane aux étapes suivantes :
- une première étape d'implantation par bombardement de la face plane de la plaquette au moyen d'ions créant, dans le volume de la plaquette et à une profondeur voisine de la profondeur de pénétration des ions, une couche de "microbulle gazeuse" séparant la plaquette en une région inférieure constituant la masse du substrat et une région supérieure constituant le film mince, les ions étant choisis parmi les ions de gaz rares ou de gaz hydrogène ;
- une deuxième étape de mise en contact intime de la face plane de la plaquette avec un support constitué au moins d'une couche de matériau rigide. Ce contact intime pouvant être réalisé par exemple à l'aide d'une substance adhésive ou par l'effet d'une préparation préalable des surfaces et éventuellement d'un traitement thermique ou/et électrostatique pour favoriser les liaisons interatomiques entre le support et la plaquette ;
- une troisième étape de traitement thermique de l'ensemble plaquette et support à une température supérieure à la température durant laquelle l'implantation a été effectuée et suffisante pour créer une séparation entre le film mince et la masse du substrat. Cette température est supérieure ou égale à environ 400°C pour le silicium.

Cette implantation est apte à créer une couche de microbulles gazeuses qui aboutira en fin de traitement thermique à une zone de fracture. Cette couche de microbulles créée ainsi dans le volume de la plaquette, à une profondeur voisine de la profondeur moyenne de pénétration des ions, délimite dans le volume de la plaquette deux régions séparées par cette couche : une région destinée à constituer le film mince et une région formant le reste du substrat. Au cours de la troisième étape, le traitement thermique est réalisé à une température suffisante pour créer, par effet de réarrangement cristallin dans le matériau semiconducteur tel que par exemple par effet de croissance des microcavités et/ou par effet de pression des microbulles, la zone de fracture et la séparation entre les deux régions.

Suivant les conditions d'implantation, après implantation d'un gaz comme par exemple l'hydrogène, des cavités ou microbulles sont observables ou non en microscopie électronique à transmission. Dans le cas du silicium, on peut avoir des microcavités dont la taille peut varier de quelques nm à quelques centaines de nm. Ainsi, en particulier lorsque la température d'implantation est faible, ces cavités ne sont observables qu'au cours de l'étape de traitement thermique, étape au cours de laquelle on réalise alors une nucléation pour permettre d'aboutir en fin de traitement thermique à la fracture entre le film mince et le reste du substrat.

Jusqu'à présent on pensait que le procédé divulgué par le document FR-A-2 681 472 ne pouvait s'appliquer qu'à la réalisation d'un film mince à partir d'un substrat de matériau semiconducteur. Dans ce document, on propose l'explication suivante aux différents phénomènes constatés par l'expérience. Tout d'abord, la première étape d'implantation ionique est menée en présentant à un faisceau d'ions une face plane d'une plaquette de matériau semiconducteur, le plan de cette face plane étant soit sensiblement parallèle à un plan cristallographique principal dans le cas où le matériau semiconducteur est parfaitement monocristallin, soit faiblement incliné par rapport à un plan cristallographique principal de mêmes indices pour tous les grains dans le cas où le matériau est polycristallin. On crée ainsi dans le volume de la plaquette, à une profondeur voisine de la profondeur moyenne de pénétration des ions, une couche de "microbulles gazeuses" correspondant à des zones de fragilisation et délimitant, dans le volume de la plaquette deux régions séparées par cette couche : une région destinée à constituer le film mince et une région formant le reste du substrat. Par l'expression "microbulles gazeuses" on entend toute cavité ou microcavité générée par l'implantation d'ions de gaz hydrogène ou de gaz rares dans le matériau. Les cavités peuvent se présenter sous forme très aplatie, c'est-à-dire de faible hauteur, par exemple de l'ordre de quelques distances inter-atomiques, aussi bien que sous forme sensiblement sphérique ou sous tout autre forme différente des deux formes précédentes. Ces cavités peuvent ou non contenir une phase gazeuse libre et/ou des atomes de gaz issus des ions implantés fixés sur des atomes du matériau formant les parois des cavités. Ces cavités sont généralement appelées en terminologie anglo-saxonne "platelets", "microblisters" ou même "bubbles". Au cours de la troisième étape, le traitement thermique est réalisé à une température suffisante (pour la durée du traitement appliqué) pour créer la séparation entre les deux régions. Le couple temps et température du traitement thermique dépend de la dose d'ions implantés.

Le procédé décrit dans le document FR-A-2 681 472 se rapporte à la réalisation d'un film mince à partir d'un substrat en matériau semiconducteur de structure cristalline. Le déroulement des différentes étapes du procédé a été expliqué comme résultant de l'interaction entre des ions implantés et la maille cristalline du matériau semiconducteur.

Cependant, les inventeurs de la présente invention ont eu la surprise de constater que ce procédé pouvait s'appliquer à tous les types de matériaux solides, cristallins ou non. Il est possible d'appliquer ce procédé à des matériaux diélectriques, conducteurs, semi-isolants, ainsi qu'à des matériaux semiconducteurs amorphes et même aux semiconducteurs polycristallins dont les grains n'ont pas de plans cristallographiques principaux sensiblement parallèles à la face plane de la plaquette. Ces derniers, ainsi que les semiconducteurs amorphes seront désignés dans la suite de la description par l'expression semiconducteurs non ordonnés. En outre, ce procédé ne modifie pas fondamentalement les propriétés du matériau auquel il s'applique.

Les inventeurs de la présente invention ont eu la surprise de constater que l'implantation d'ions de gaz hydrogène ou de gaz rares peut aussi provoquer la formation de microcavités dans des matériaux solides autres qu'un matériau semiconducteur cristallin, et qu'un traitement thermique subséquent peut provoquer la séparation, au niveau des microcavités, de la masse du matériau en deux parties. En effet, le traitement thermique conduit, quel que soit le type de matériau solide, à la coalescence des microcavités qui amènent une fragilisation de la structure au niveau de la couche de microcavités. Cette fragilisation permet la séparation du matériau sous l'effet de contraintes internes et/ou de pression dans les microcavités, cette séparation pouvant être naturelle ou assistée par application de contraintes externes.

On entend par couche de microcavités une zone contenant des microcavités pouvant être situées à différentes profondeurs et pouvant être adjacentes ou non entre elles.

L'invention a donc pour objet un procédé de réalisation d'un film mince de matériau solide, cristallin ou non, choisi parmi un matériau diélectrique, un matériau conducteur, un matériau semi-isolant, un matériau semiconducteur non ordonné c'est-à-dire un matériau semiconducteur amorphe ou un matériau semiconducteur polycristallin dont les grains n'ont pas de plans cristallographiques principaux sensiblement parallèles à une face plane d'une plaquette, consistant à soumettre un substrat dudit matériau solide aux étapes suivantes :
- une étape d'implantation ionique au cours de laquelle une face du substrat est bombardée par des ions choisis parmi les ions de gaz rares et de gaz hydrogène, afin de créer, dans le volume du substrat et à une profondeur voisine de la profondeur moyenne de pénétration des ions, une couche de microcavités séparant le substrat en deux régions,
- une étape de traitement thermique destinée à porter la couche de microcavités à une température suffisante pour provoquer une séparation encre les deux régions du substrat soit naturellement, soit avec l'aide d'une contrainte appliquée,
- et optionnellement, entre l'étape d'implantation ionique et l'étape de traitement thermique, il est prévu une étape de fixation de ladite face du substrat sur un support.

Cette étape optionnelle peut être nécessaire au cas où la couche mince n'est pas suffisamment rigide par elle-même. Elle peut être désirée puisque, généralement, la couche mince est destinée à être placée sur un support. Dans ce cas, le support doit pouvoir supporter l'étape de traitement thermique finale.

La fixation de ladite face du substrat sur le support peut se faire au moyen d'une substance adhésive ou au moyen d'un traitement favorisant les liaisons interatomiques.

Ce procédé selon l'invention s'applique notamment à l'obtention d'un film mince de matériau ferroélectrique, à partir d'un substrat en matériau ferroélectrique, et à sa fixation sur un support.

Avantageusement, le support étant en matériau semiconducteur, au moins un circuit de commande électronique est élaboré sur une face de ce support, le film mince de matériau ferroélectrique est fixé sur le support de façon à servir de diélectrique à une capacité mémoire commandée par ledit circuit de commande électronique pour constituer ainsi un point mémoire.

De préférence, le circuit de commande électronique est du type à transistor MOS.

Le procédé selon l'invention peut aussi être appliqué pour obtenir un film mince de saphir sur un support, un film mince de métal résistant à la corrosion sur un support ou un film mince de matériau magnétique sur un support.

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 est une vue partielle en coupe transversale d'un circuit intégré réalisé sur une face d'un substrat semiconducteur,
- la figure 2 illustre l'étape d'implantation ionique effectuée au travers d'une face d'un substrat en matériau ferroélectrique, selon la présente invention,
- la figure 3 illustre l'étape de fixation selon la présente invention, consistant à faire adhérer la face du substrat semiconducteur où le circuit intégré a été réalisé sur la face du substrat en matériau ferroélectrique ayant été bombardée par les ions,
- la figure 4 illustre l'étape du procédé selon l'invention conduisant à la séparation du film mince du reste du substrat en matériau ferroélectrique,
- la figure 5 est une vue partielle en coupe d'un point mémoire à condensateur ferroélectrique réalisé selon la présente invention.

Le procédé selon l'invention s'applique aux matériaux solides, cristallins ou non, suivants :
- les matériaux isolants ou diélectriques,
- les matériaux conducteurs,
- les matériaux semiconducteurs non ordonnés,
- les matériaux semi-isolants, principalement ceux dont la résistivité à température ambiante est supérieure à environ 10⁷Ω.cm,
- les métaux monocristallins et les supraconducteurs de façon générale.

Il est ainsi possible selon l'invention de réaliser des films minces de quartz monocristallin à partir de quartz monocristallin massif. On peut également obtenir des films minces de matériaux magnétiques, piézoélectriques, ferroélectriques, pyroélectriques, des matériaux présentant des propriétés d'optique non linéaire ou des effets électro-optiques, acousto-optiques.

On va décrire maintenant un exemple particulier : la réalisation de mémoires à condensateurs ferroélectriques sur un circuit intégré.

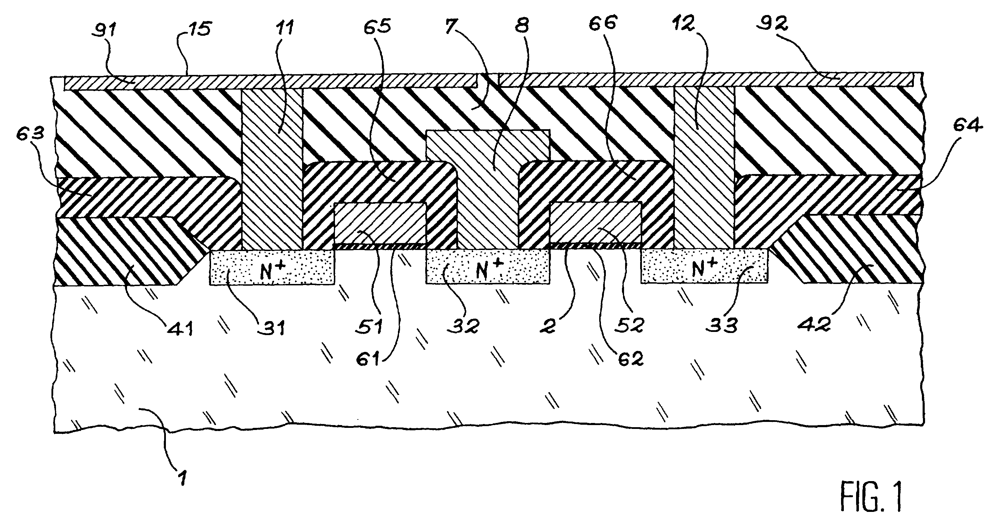

Le circuit électronique représenté en coupe à la figure 1 a été réalisé selon les techniques actuelles de la micro-électronique. On a mis en oeuvre la technique dite "plug", la technique de planarisation mécanochimique des oxydes et la technique dite "Damascene" permettant de réaliser des connexions enterrées dans un oxyde mais affleurant à la surface de celui-ci.

Le circuit a été élaboré sur une face 2 d'un substrat 1 en silicium de type P. A partir de la face 2 on a réalisé des caissons, seuls les caissons 31, 32 et 33 de type N⁺ étant représentés sur cette figure, et on a fait croître de l'oxyde de champ pour obtenir des zones d'isolation 41 et 42 à gauche du caisson 31 et à droite du caisson 33. Les caissons 31 et 33 sont destinés à constituer les drains de deux transistors de type MOS, le caisson 32 constituant leur source commune. Sur la face 2, des lignes de mots 51 et 52 en silicium polycristallin ont été déposées, avec interposition de couches d'oxyde mince 61 et 62. Les lignes de mots 51 et 52 ont été recouvertes de couches de matériau isolant 65 et 66. Ce matériau isolant recouvre aussi les zones 41 et 42 sous forme de couches 63 et 64. Une ligne de bits 8 en aluminium assure le contact électrique avec la source 32. Une couche d'oxyde 7 a été déposée pour recouvrir l'ensemble des éléments décrits précédemment. Dans la couche d'oxyde 7 sont déposées des électrodes affleurantes 91 et 92 en platine et pourvues de sous-couches barrière en TiN. Les électrodes 91 et 92 sont connectées par des "plugs" 11 et 12 aux drains 31 et 33 des transistors. Elles sont enterrées, le circuit présentant alors une face plane externe 15.

On va maintenant décrire la réalisation d'un film mince en matériau ferroélectrique selon le procédé de la présente invention, ce film mince étant destiné à former le diélectrique de condensateurs.

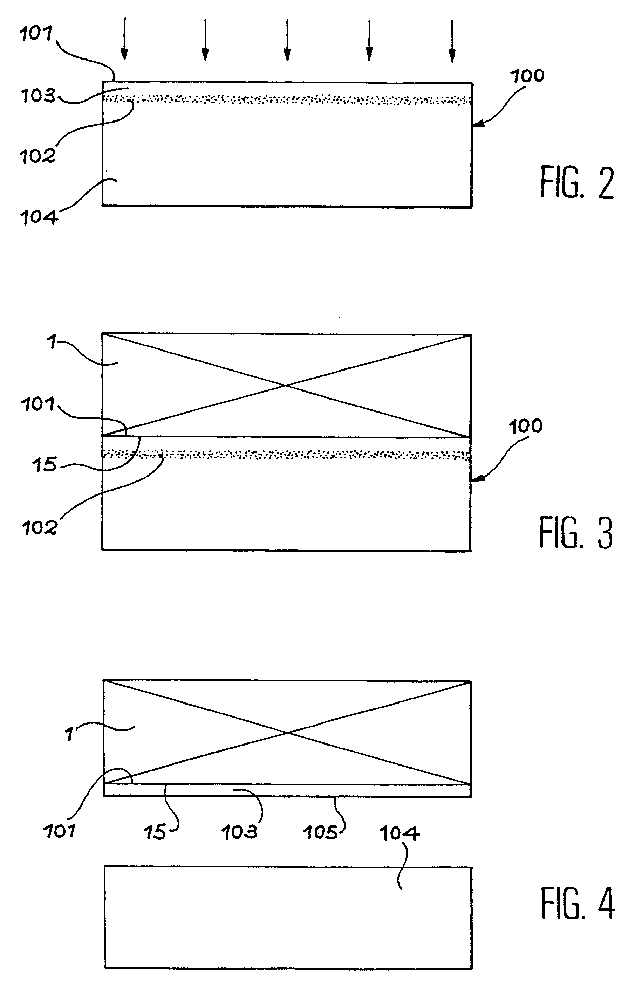

La figure 2 représente, vu latéralement, un substrat 100 en matériau ferroélectrique, par exemple en PbZrTiO₃ (PZT). La face plane 101 du substrat 100 est bombardée par des ions, par exemple des ions hydrogène d'énergie 200 keV et selon une dose égale à 10¹⁷ cm⁻². Le bombardement ionique est figuré par des flèches sur la figure 2. Les ions implantés induisent des microcavités qui se répartissent dans une couche 102 au voisinage d'un plan parallèle à la face plane 101, ce plan étant situé à une distance de la face plane 101 correspondant à la profondeur moyenne de pénétration des ions. La couche 102 de matériau implanté à une épaisseur très faible, de l'ordre de quelques dizaines de nm, par exemple de 50 à 100 nm. Elle sépare le substrat 100 en deux régions : une première région 103, située du côté de la face plane 101 et destinée à former le film mince, et une seconde région 104 formant le reste du substrat. L'épaisseur de la région 103 est d'environ 800 nm. La couche 102 est formée d'une couche de microcavités.

La face plane 101 du substrat en matériau ferroélectrique 100 et la face plane 15 du circuit électronique réalisé sur le substrat semiconducteur 1 sont traitées par exemple par voie chimique de façon à les rendre adhérentes entre elles par simple mise en contact. La figure 3 représente les deux substrats 100 et 1 associés, la face plane 15 du substrat semiconducteur 1 adhérant à la face plane 101 du substrat 100 en matériau ferroélectrique.

L'ensemble est alors traité thermiquement à environ 500°C, ce qui a pour conséquence d'induire une séparation des deux régions 103 et 104 du substrat 100 en matériau ferroélectrique au niveau de la couche 102 comme le montre la figure 4. On obtient un substrat semiconducteur pourvu d'un circuit électronique auquel est fixé un film mince en matériau ferroélectrique.

La face externe 105 du film mince 103 est éventuellement polie finement.

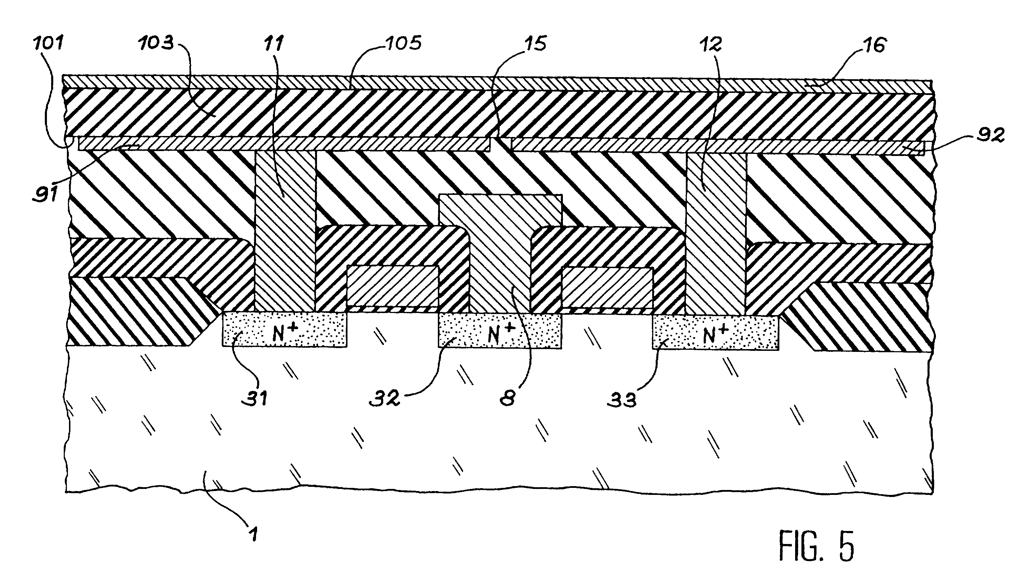

On obtient le dispositif représenté à la figure 5 où un point mémoire à deux condensateurs est constitué par le dépôt sur la face plane 105 du film mince 103 d'une électrode commune 16.

Une encapsulation finale peut être ajoutée pour protéger l'ensemble du circuit.

Un tel film mince ferroélectrique peut également être utilisé pour constituer une couche de matériau ferroélectrique déposée directement sur le silicium pour réaliser des transistors MOS où la grille de commande est remplacée par cette couche ferroélectrique dont l'état de polarisation détermine l'état bloqué ou passant du transistor.

L'application du procédé selon l'invention aux matériaux diélectriques permet notamment de réaliser des couches anti-usure en saphir (β-alumine) sur des supports en verre ou en silice. Une telle couche mince d'alumine permet de protéger le verre ou la silice servant de support par exemple à des composants optiques de l'usure et des rayures. Une implantation d'ions hydrogène d'environ 8.10¹⁶ atomes/cm² et de 110 keV d'énergie permet d'obtenir une couche mince ou saphir d'environ 1 µm d'épaisseur. Cette faible épaisseur est compatible avec une mise en forme ultérieure éventuelle du verre ou de la silice servant de support pour réaliser des optiques par exemple.

Le procédé selon l'invention s'applique aussi aux matériaux métalliques. Il permet de réaliser des couches anti-corrosion et des barrières de diffusion. La possibilité de réaliser des couches monocristallines métalliques au lieu de couches polycristallines apporte un avantage significatif en termes d'efficacité comme barrière de diffusion aux agressions chimiques et à la corrosion en particulier. En effet, l'existence de phénomènes de diffusions importantes aux joints de grains, dans les matériaux polycristallins, limite l'efficacité des couches minces réalisées en ces matériaux. A titre d'exemple, on peut citer le dépôt d'un film mince de niobium monocristallin de 500 nm d'épaisseur sur un substrat d'acier pour la réalisation d'objets devant résister à des températures élevées en milieu corrosif. Pour obtenir ce film mince, on peut mettre en oeuvre une implantation d'ions H⁺ d'environ 2.10¹⁷ atomes/cm² à 200 keV d'énergie.

Un autre exemple d'application concerne la réalisation de mémoires utilisant, pour le stockage de l'information, des domaines magnétiques (bulles) et les parois de domaines magnétiques (parois de Bloch). Pour cela, on peut partir d'un substrat massif de grenat non magnétique sur lequel on a fait croître par épitaxie une couche de grenat ferrimagnétique. Le procédé selon l'invention permet de reporter une couche mince de matériau en grenat ferrimagnétique sur un substrat en silicium servant de support et comportant des circuits intégrés. Ces circuits intégrés combinent des dispositifs électroniques, logiques et analogiques, des microbobinages intégrés aptes à générer des champs magnétiques localisés de façon à piloter, déplacer et détecter les domaines magnétiques ou les parois des domaines dans la couche mince de grenat ferrimagnétique.

## Revendications

1. Procédé de réalisation d'un film mince de matériau solide (103), cristallin ou non, choisi parmi un matériau diélectrique, un matériau conducteur, un matériau semi-isolant, un matériau semiconducteur non ordonné c'est-à-dire un matériau semiconducteur amorphe ou un matériau semiconducteur polycristallin dont les grains n'ont pas de plans cristallographiques principaux sensiblement parallèles à une face plane d'une plaquette, consistant à soumettre un substrat (100) dudit matériau solide aux étapes suivantes :
- une étape d'implantation ionique au cours de laquelle une face (101) du substrat (100) est bombardée par des ions choisis parmi les ions de gaz rares et de gaz hydrogène, afin de créer, dans le volume du substrat (100) et à une profondeur voisine de la profondeur moyenne de pénétration des ions, une couche de microcavités (102) séparant le substrat en deux régions (103, 104),
- une étape de traitement thermique destinée à porter la couche de microcavités (102) à une température suffisante pour provoquer une séparation entre les deux régions (103, 104) du substrat soit naturellement, soit avec l'aide d'une contrainte appliquée,
- et optionnellement, entre l'étape d'implantation ionique et l'étape de traitement thermique, il est prévu une étape de fixation de ladite face (101) du substrat (100) sur un support (1).

2. Procédé selon la revendication 1, caractérisé en ce que ladite face (101) du substrat (100) est fixée sur le support (1) au moyen d'une substance adhésive.

3. Procédé selon la revendication 1, caractérisé en ce que ladite face (101) du substrat (100) est fixée sur le support (1) par un traitement favorisant les liaisons interatomiques.

4. Application du procédé selon l'une quelconque des revendications 1 à 3 pour obtenir un film mince (103) de matériau ferroélectrique, à partir d'un substrat (100) en matériau ferroélectrique, et sa fixation sur un support (1).

5. Application selon la revendication 4, caractérisée en ce que, le support (1) étant en matériau semi-conducteur, au moins un circuit de commande électronique est élaboré sur une face (15) de ce support (1), le film mince (103) de matériau ferroélectrique est fixé sur le support (1) de façon à servir de diélectrique à une capacité mémoire commandée par ledit circuit de commande électronique pour constituer ainsi un point mémoire.

6. Application selon la revendication 5, caractérisée en ce que le circuit de commande électronique est du type à transistor MOS.

7. Application du procédé selon l'une quelconque des revendications 1 à 3 pour obtenir un film mince de saphir sur un support.

8. Application du procédé selon l'une quelconque des revendications 1 à 3 pour obtenir un film mince de métal résistant à la corrosion sur un support.

9. Application du procédé selon l'une quelconque des revendications 1 à 3 pour obtenir un film mince de matériau magnétique sur un support.

## Claims

1. Method for producing a thin film of solid material (103), crystalline or noncrystalline, chosen among a dielectric material, a conducting material, a semi-insulating material, an unorganized semiconducting material, comprising subjecting a substrate (100) of said solid material to the following steps:
- an ion implantation step during which one face (101) of the substrate (100) is bombarded with ions chosen among rare gas and hydrogen gas ions so as to create, in the body of the substrate (100) at a depth neighbouring the average ion penetration depth, a layer of microcavities (102) separating the substrate into two regions (103, 104),
- a heat treatment step intended to heat the layer of microcavities (102) to a temperature sufficient to bring about a separation between the two regions (103, 104) of the substrate, either naturally or by means of an applied stress,
- and optionally between the ion implantation step and the heat treatment step, a step for fixing said face (101) of the substrate (100) to a support (1).

2. Method according to claim 1, characterized in that said face (101) of the substrate (100) is fixed on the support (1) by means of an adhesive substance.

3. Method according to claim 1, characterized in that said face (101) of the substrate (100) is fixed on the support (1) by means of a treatment favouring interatomic bonds.

4. Application of the method according to any of claims 1 to 3 to obtain a thin film (103) of ferroelectric material using a substrate (100) of ferroelectric material, and to fix it on a support (1).

5. Application according to claim 4, characterized in that, the support (1) being of semiconducting material, at least one electronic control circuit is elaborated on one face (15) of this support (1) and the thin film (103) of ferroelectric material is fixed on the support (1) so as to serve as a dielectric for a memory capacitor controlled by said electronic control circuit to thus make up a memory point.

6. Application according to claim 5, characterized in that the electronic control circuit is of MOS transistor type.

7. Application of the method according to any of claims 1 to 3 to obtain a thin sapphire film on a support.

8. Application of the method according to any of claims 1 to 3 to obtain a thin corrosion-resisting metal film on a support.

9. Application of the method according to any of claims 1 to 3 to obtain a thin film of magnetic material on a support.

## Patentansprüche

1. Realisierungsmethode einer Dünnschicht aus festem Material (103), kristallin oder nicht, ausgewählt unter einem dielektrischen Material, einem leitfähigen Material, einem semi-isolierenden Material, einem ungeordneten Halbleiterematerial, d.h. einem amorphen Halbleitermaterial oder einem polykristallinen Halbleitermaterial, dessen Körner keine kristallographischen Hauptflächen haben, die im wesentlichen parallel zu einer planen Fläche eines Plättchens sind,
darin bestehend, ein Substrat (100) aus dem genannten festen Material den folgenden Schritten zu unterziehen:
- einem Ionenimplantationsschritt, in dessen Verlauf eine Fläche (101) des Substrats (100) mit Ionen bombardiert wird, die zwischen den Edelgas- und den Wasserstoffionen ausgewählt werden, um in dem Volumen des Substrats (100) und in einer ungefähr der mittleren Eindringtiefe der Ionen entsprechenden Tiefe eine Schicht mit Mikrohohlräumen (102) zu erzeugen, die das Substrat in zwei Bereiche (103, 104) unterteilt,
- einem Wärmebehandlungsschritt, um die Schicht mit den Mikrohohlräumen (102) auf eine Temperatur zu bringen, die ausreicht, eine Trennung zwischen den beiden Bereichen (103, 104) des Substrats zu verursachen, entweder natürlich oder mit Hilfe einer angewendeten Belastung,
- und wahlweise, zwischen dem Implantationsschritt und dem Wärmebehandlungsschritt, einen Befestigungsschritt der genannten Fläche (101) des Substrats (100) auf einem Träger (1).

2. Verfahren nach Anspruch 1, dadurch gekennzeichnet, dass die genannte Fläche (101) des Substrats (100) auf dem Träger (1) mit Hilfe einer haftenden Substanz befestigt wird.

3. Verfahren nach Anspruch 1, dadurch gekennzeichnet, dass die genannte Fläche (101) des Substrats (100) auf dem Träger (1) durch eine Behandlung befestigt wird, die die interatomaren Bindungen begünstigt.

4. Anwendung nach einem der Ansprüche 1 bis 3, um aus einem Substrat (100) aus ferroelektischen Material einen Dünnfilm (103) aus ferroelektrischem Material und seine Befestigung auf einem Träger (1) zu realisieren.

5. Anwendung nach Anspruch 4, dadurch gekennzeichnet, dass der Träger (1) aus Halbleitermaterial ist, wobei wenigstens eine elektronische Steuerschaltung auf einer Fläche (15) dieses Trägers (1) hergestellt ist und der Dünnfilm (103) aus ferroelektrischem Material auf dem Träger (1) so befestigt ist, dass er als Dielektrikum dient, mit einer Speicherkapazität, die durch die genannte elektronische Steuerschaltung gesteuert wird, um so einen Speicherpunkt zu bilden.

6. Anwendung nach Anspruch 5, dadurch gekennzeichnet, dass die elektronische Steuerschaltung vom MOS-Transistor-Typ ist.

7. Anwendung nach einem der Ansprüche 1 bis 3, um auf einem Träger einen Saphir-Dünnfilm zu erhalten.

8. Anwendung nach einem der Ansprüche 1 bis 3, um auf einem Träger einen Dünnfilm aus korrosionsfestem Metall zu erhalten.

9. Anwendung nach einem der Ansprüche 1 bis 3, um auf einem Träger einen Dünnfilm aus magnetischem Material zu erhalten.
